# EUROPEAN PATENT APPLICATION

(11) **EP 4 657 412 A1**
(43) Date of publication of application: **03.12.2025**
(21) Application number: 24858118.3
(22) Date of filing: 17.07.2024
(51) Int. Cl.: G09F 9/30, H04W 4/80

(54) **DISPLAY MODULE AND DISPLAY DEVICE**

(30) Priority: 31.08.2023 CN 202311119096
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: CHENG, Hao, Beijing 100176 (CN); BI, Xin, Beijing 100176 (CN); HOU, Dianjie, Beijing 100176 (CN); TAO, Xuan, Beijing 100176 (CN); CHEN, Xiao, Beijing 100176 (CN); WU, Jianjun, Beijing 100176 (CN); FAN, Qiang, Beijing 100176 (CN); HUANG, Wen, Beijing 100176 (CN)
(74) Representative: Durán-Corretjer, S.L.P.
(86) International application number: PCT/CN2024/105989
(87) International publication number: WO 2025/044574

(57) **Abstract**

A display module and a display device. The display module comprises a display panel (5) and a near field communication structure (9); the display panel (5) comprises a display portion (13), a bent portion (14), and a binding potion (15) which are connected in sequence; the bent portion (14) is bent to a backlight side (23) of the display portion (13); the near field communication structure (9) is located on the backlight side (23) of the display potion (13); the display portion (13), the near field communication structure (9), and the binding portion (15) are sequentially arranged in a direction perpendicular to the display portion (13); and the orthographic projection (B) of the near field communication structure (9) on the display portion (13) at least partially overlaps the orthographic projection (A) of the binding portion (15) on the display portion (13). By increasing the area of the near field communication structure (9), the semaphore of the near field communication structure (9) is improved, and the near field communication performance of the display module is ensured.

## Description

The present application claims priority to Chinese Patent Application No. 202311119096.9, filed to the CNIPA on August 31, 2023 and entitled "Display Module and Display Device", contents of which should be construed as being incorporated into the present application by reference.

### Technical Field

The present disclosure relates to, but is not limited to, the field of display apparatus, and particularly relates to a display module and a display device.

### Background

An organic light emitting diode (OLED) and a quantum dot light emitting diode (QLED) are active light emitting display apparatus and have advantages of self-illumination, a wide viewing angle, a high contrast ratio, low power consumption, an extremely high reaction speed, lightness and thinness, flexibility, and a low cost, etc. With continuous development of display technologies, a flexible display device (Flexible Display) in which an OLED or a QLED is used as a light emitting apparatus and signal control is performed through a thin film transistor (TFT) has become a mainstream product in the field of display at present.

At present, some display apparatuses have a near field communication (NFC) structure, but there is a problem that the signal quantity of the near field communication structure is insufficient.

### Summary

The following is a summary of subject matters described herein in detail. This summary is not intended to limit the protection scope of claims.

The technical problem to be solved by the present disclosure is to provide a display module, which increases the area of a near field communication structure, improves the signal quantity of the near field communication structure, ensures the performance of short range wireless communication of the display module, and solves the problem that the signal quantity of the near field communication structure is insufficient.

At least one embodiment of the present disclosure provides a display module, including: a display panel including a display portion, a bending portion, and a bonding portion, the display portion, the bending portion, and the bonding portion being sequentially connected, and the bending portion being folded to a backlight side of the display portion; and a near field communication structure located on the backlight side of the display portion. The display portion, the near field communication structure, and the bonding portion are sequentially arranged in a direction perpendicular to the display portion, and an orthographic projection of the near field communication structure on the display portion at least partially overlaps with an orthographic projection of the bonding portion on the display portion.

In an exemplary embodiment, a first back film layer located on a surface of the bonding portion close to the display portion is further included, and the near field communication structure is configured to be adhered to the first back film layer.

In an exemplary embodiment, a surface of the near field communication structure facing the first back film layer is provided with a double-sided adhesive for adhering, and the double-sided adhesive is provided as an acrylic hot melt adhesive.

In an exemplary embodiment, a thickness of the double-sided adhesive is configured to be 0.02 mm to 0.05 mm.

In an exemplary embodiment, a composite film disposed between the near field communication structure and the display portion is further included, and a thickness of the composite film is configured to be less than 0.16 mm.

In an exemplary embodiment, the composite film includes a first film layer and a mesh adhesive, the first film layer and the mesh adhesive are stacked in the direction perpendicular to the display portion, and the first film layer is provided as a graphite layer, a foam glue layer, or a polyimide layer.

In an exemplary embodiment, a thickness of the first film layer is configured to be 0.05 to 0.07 mm, and a thickness of the mesh adhesive is configured to be 0.02mm to 0.04 mm.

In an exemplary embodiment, the thickness of the composite film is configured to be 0.06 mm to 0.12 mm.

In an exemplary embodiment, a conductive member for grounding the display panel is further included.

The near field communication structure includes a ferrite plate and a copper foil, the ferrite plate and the copper foil are stacked in the direction perpendicular to the display portion, and the copper foil is located on a side of the ferrite plate away from the display portion.

The ferrite plate is provided with a first through hole, the conductive member penetrates the first through hole, one end of the conductive member abuts against the copper foil, and the conductive member is configured to be spaced apart from with an inner side wall of the first through hole.

In an exemplary embodiment, a composite film and a second back film layer are further included. The second back film layer is disposed on a surface of the display portion facing the near field communication structure.

The second back film layer, the composite film, and the near field communication structure are sequentially stacked in the direction perpendicular to the display portion.

The composite film is provided with a second through hole, the second through hole is in communication with the first through hole, and the first through hole and the second through hole constitute an accommodation cavity.

One end of the conductive member away from the copper foil abuts against the second back film layer, the conductive member sequentially penetrates the first through hole and the second through hole, and the conductive member is configured to be spaced apart from an inner side wall of the second through hole.

In an exemplary embodiment, a plurality of conductive members are provided, a plurality of accommodation cavities are provided, and the conductive members and the accommodation cavities are provided in one-to-one correspondence.

In an exemplary embodiment, a cross-sectional shape of the conductive member in a plane parallel to the display portion is configured to be rectangular, circular, rhombic, triangular, trapezoidal or irregular pattern, and hole patterns of the second through hole and the first through hole are configured to be the same as the cross-sectional shape of the conductive member in the plane parallel to the display portion.

In an exemplary embodiment, the conductive member is provided as a conductive foam or a conductive double-sided adhesive.

In an exemplary embodiment, a cross-sectional area of the conductive member in a plane parallel to the display portion is configured to be greater than or equal to 5 mm².

In an exemplary embodiment, the near field communication structure includes a ferrite plate and a first trace disposed on the ferrite plate. At least a part of an orthographic projection of the first trace on the display portion is configured to overlap with at least a part of the orthographic projection of the bonding portion on the display portion, or at least a part of the orthographic projection of the first trace on the display portion is configured to not overlap with the orthographic projection of the bonding portion on the display portion.

In an exemplary embodiment, a chip provided on a surface of the bonding portion away from the near field communication structure is further included. An orthographic projection of the chip on the display portion is within an orthographic projection of the near field communication structure on the display portion.

In an exemplary embodiment, the orthographic projection of the near field communication structure on the display portion is provided as a first projection, an orthographic projection of the bonding portion on the display portion is provided as a second projection, and a projection area where the second projection overlaps with the first projection is configured to be greater than two-thirds of a projection area of the second projection.

In an exemplary embodiment, a projection area of the orthographic projection of the near field communication structure on the display portion is not less than two-thirds of an area of the display portion.

In an exemplary embodiment, a cover plate, a curable optical adhesive, a polarizer, and an encapsulation layer that are located on a light emitting side of the display portion are further included. The encapsulation layer, the polarizer, the curable optical adhesive, and the cover plate are sequentially stacked in a direction away from the display portion.

At least an embodiment of the present disclosure provides a display device which includes the above display module.

Other features and advantages of the present application will be set forth in the specification which follows, and in part will become apparent from the specification, or may be learned by practice of the present application. Other advantages of the present application may be achieved and obtained through solutions described in the specification and drawings.

### Brief Description of Drawings

Accompanying drawings are intended to provide an understanding of technical solutions of the present application and form a part of the specification, and are used to explain the technical solutions of the present application together with embodiments of the present application, and do not constitute a limitation on the technical solutions of the present application.
FIG. 1 is a schematic diagram of a related display module;
FIG. 2 is a schematic projection diagram of a near field communication structure in FIG. 1;
FIG. 3 is a schematic diagram of a display module according to an exemplary embodiment of the present disclosure;
FIG. 4 is a schematic projection diagram of a near field communication structure and a bonding portion in FIG. 3;
FIG. 5 is a schematic diagram of a display panel in FIG. 3;
FIG. 6 is a partial schematic diagram of the display module in FIG. 3;
FIG. 7 is a schematic diagram of a near field communication structure according to an exemplary embodiment of the present disclosure;
FIG. 8 is a schematic projection diagram of the near field communication structure in FIG. 7 on a display portion;
FIG. 9 is a schematic diagram of another near field communication structure according to an exemplary embodiment of the present disclosure;
FIG. 10 is a schematic projection diagram of the near field communication structure in FIG. 9 on a display portion;
FIG. 11 is another schematic projection diagram of the near field communication structure in FIG. 9 on the display portion;
FIG. 12 is a schematic diagram of another near field communication structure according to an exemplary embodiment of the present disclosure;
FIG. 13 is a schematic projection diagram of the near field communication structure in FIG. 12 on a display portion;
FIG. 14 is another schematic projection diagram of the near field communication structure in FIG. 12 on the display portion;
FIG. 15 is a schematic diagram of another near field communication structure according to an exemplary embodiment of the present disclosure;
FIG. 16 is a schematic projection diagram of the near field communication structure in FIG. 15 on a display portion;
FIG. 17 is another schematic projection diagram of the near field communication structure in FIG. 15 on the display portion;
FIG. 18 is a schematic diagram of another near field communication structure according to an exemplary embodiment of the present disclosure;
FIG. 19 is a schematic projection diagram of the near field communication structure in FIG. 18 on a display portion;
FIG. 20 is another schematic projection diagram of the near field communication structure in FIG. 18 on the display portion;
FIG. 21 is a schematic diagram of another near field communication structure according to an exemplary embodiment of the present disclosure;
FIG. 22 is a schematic cross-sectional diagram of another display module according to an exemplary embodiment of the present disclosure;
FIG. 23 is a partial schematic cross-sectional diagram of the display module in FIG. 22; and
FIG. 24 is a schematic diagram of a ferrite plate in FIG. 22.

Reference signs are described as follows.

| | | |
|---|---|---|
| 1-cover plate; | 2-curable optical adhesive; | 3-polarizer; |
| 4-encapsulation layer; | 5-display panel; | 6-back film layer; |
| 7-composite film; | 8-bending spacer; | 9-near field communication structure; |
| 10-first circuit board; | 11-chip; | 12-protective adhesive layer; |
| 13-display portion; | 14-bending portion; | 15-bonding portion; |
| 16-double-sided adhesive; | 17-first back film layer; | 18-second back film layer; |
| 19-first board section; | 20-second board section; | 21-first bend; |
| 22-light emitting side; | 23-back light side; | 24-first gap; |
| 25-first film layer; | 26-mesh adhesive; | 27-ferrite plate; |
| 28-first trace; | 29-first region; | 30-first edge; |
| 31-notch; | 32-second edge; | 33-copper foil; |
| 34-conductive member; | 35-first through hole; | 36-second through hole; |
| 37-accommodation cavity; | 38-second gap; | 39-third gap. |

### Detailed Description

To make objectives, technical solutions, and advantages of the present disclosure clearer, the embodiments of the present disclosure will be described in detail below with reference to the accompanying drawings. It is to be noted that implementations may be implemented in multiple different forms. Those of ordinary skills in the art may easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

Ordinal numerals "first", "second", "third", and the like in the specification are set not to form limits in numbers but only to avoid confusion between constituent elements.

In the specification, for convenience, expressions "central", "above", "below", "front", "back", "vertical", "horizontal", "top", "bottom", "inside", "outside", and the like for indicating directional or positional relationships are used to illustrate positional relationships between the constituent elements with reference to the accompanying drawings, not to indicate or imply that involved apparatus or elements are required to have specific orientations or are structured and operated in the specific orientations but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, a connection may be a fixed connection, or a detachable connection, or an integral connection; it may be a mechanical connection or an electrical connection; it may be a direct connection, or an indirect connection through a middleware, or an internal communication between two elements. Those of ordinary skills in the art may understand specific meanings of the above terms in the present disclosure according to specific situations.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, other elements with various functions, etc.

In the specification, "parallel" refers to a state in which an angle formed by two straight lines is above -10° and below 10°, and thus also includes a state in which the angle is above -5° and below 5°. In addition, "perpendicular" refers to a state in which an angle formed by two straight lines is above 80° and below 100°, and thus also includes a state in which the angle is above 85° and below 95°.

A triangle, rectangle, trapezoid, pentagon, or hexagon, or the like in the specification is not strictly defined, and it may be an approximate triangle, rectangle, trapezoid, pentagon, or hexagon, or the like. There may be some small deformations caused by tolerance, and there may be a chamfer, an arc edge, deformation, etc.

In an embodiment of the present disclosure, "about" refers to a value that is not strictly limited, and a value within a range of process and measurement error is allowed.

Moreover, when describing representative embodiments, the specification may have presented a method and/or a process as a particular sequence of acts. However, to an extent that the method or the process does not depend on the specific sequence of the acts described herein, the method or the process should not be limited to the acts with the specific sequence. Those of ordinary skills in the art will understand that other sequences of acts may also be possible. Therefore, the specific sequence of the acts illustrated in the specification should not be interpreted as a limitation on claims. Moreover, the execution of the acts in the claims for the method and/or the process should not be limited to the written sequence, and it can be easily understood by those skilled in the art that these sequences may be changed and still fall within the spirit and scope of the embodiments of the present application.

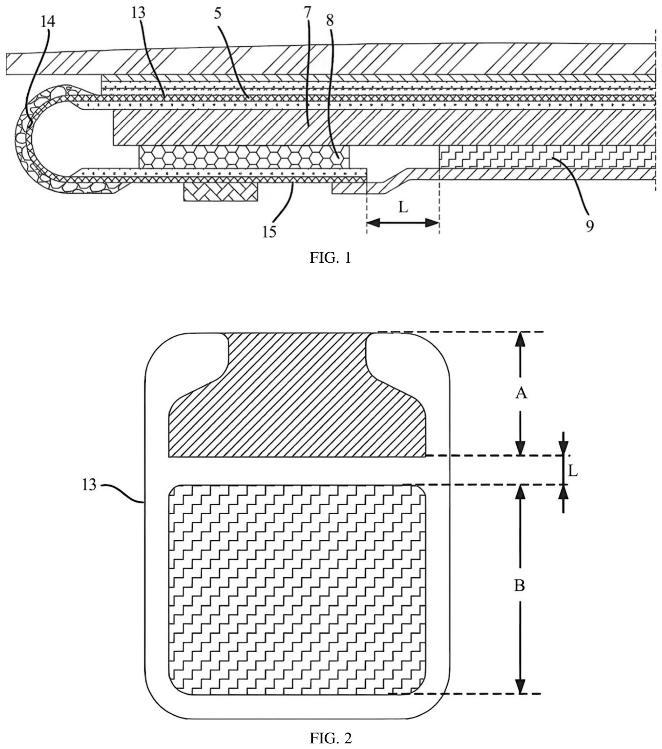

FIG. 1 is a schematic diagram of a related display module, and FIG. 2 is a schematic projection diagram of a near field communication structure in FIG. 1. As shown in FIGS. 1 and 2, the related display module includes a display panel 5, a composite film (Super Clean Foam, SCF) 7, a bending spacer 8 and a near filed communication (NFC) structure 9. The display panel 5 includes a display portion 13, a bending portion 14, and a bonding portion 15, and the composite film 7 and the bending spacer 8 support a space between the display portion 13 and the bonding portion 15. In a direction parallel to the display portion 13, a distance between the near field communication structure 9 and the bonding portion 15 may be L, and the numerical value of L is greater than or equal to 2.5 mm. For example, in some display modules, the distance between the near field communication structure 9 and the bonding portion 15 is 2.5 mm, 3 mm, or 5 mm. An orthographic projection of the bonding portion 15 on the display portion 13 is a projection A, and an orthographic projection of the near field communication structure 9 on the display portion 13 is a projection B. The projection A and the projection B are arranged apart with a distance L. The inventors of the present application have found through the research that when the overall size of the display module is small, the area of the near field communication structure 9 in the display module is too small, which leads to insufficient signal quantity of the near field communication structure 9, resulting in poor short-range wireless communication performance of the display module.

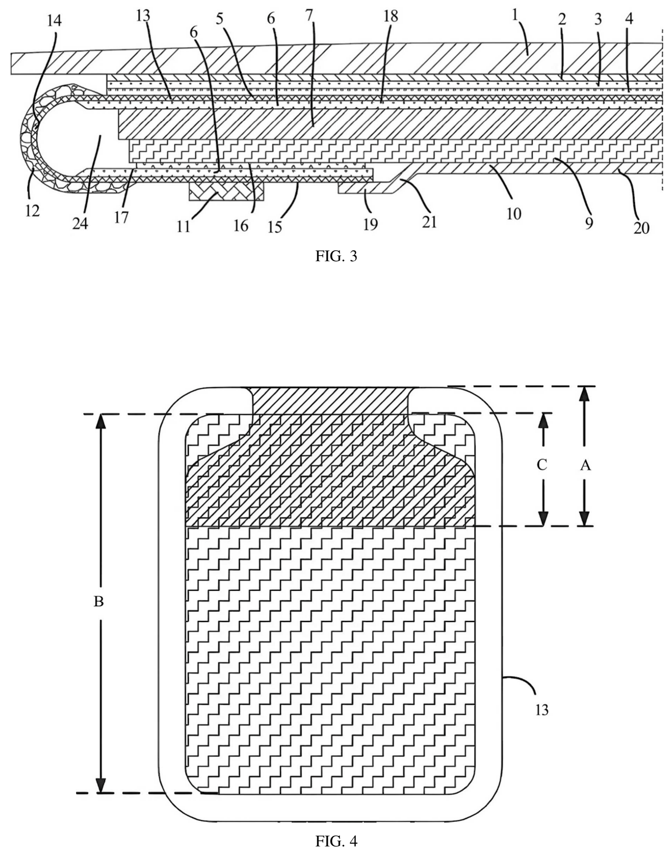

FIG. 3 is a schematic diagram of a display module according to an exemplary embodiment of the present disclosure, and FIG. 4 is a schematic projection diagram of a near field communication structure and a bonding portion in FIG. 3. An embodiment of the present disclosure provides a display module. As shown in FIGS. 3 and 4, the display module may include a display panel 5 and a near field communication structure 9. The display panel 5 may include a display portion 13, a bending portion 14, and a bonding portion 15 connected sequentially. The bending portion 14 may be folded to a backlight side of the display portion 13, and the near field communication structure 9 may be located on the backlight side of the display portion 13. The display portion 13, the near field communication structure 9, and the bonding portion 15 may be sequentially arranged in a direction perpendicular to the display portion 13, and an orthographic projection B of the near field communication structure 9 on the display portion 13 is configured to at least partially overlap with an orthographic projection A of the bonding portion 15 on the display portion 13. As a result, in the display module of the present example, the near field communication structure 9 extends between the display portion 13 and the bonding portion 15. The display module of the present example increases the area of the near field communication structure 9, improves the signal quantity of the near field communication structure 9, and ensures the short-range wireless communication performance of the display module compared to the related display module where the near field communication structure 9 does not extend between the display portion 13 and the bonding portion 15.

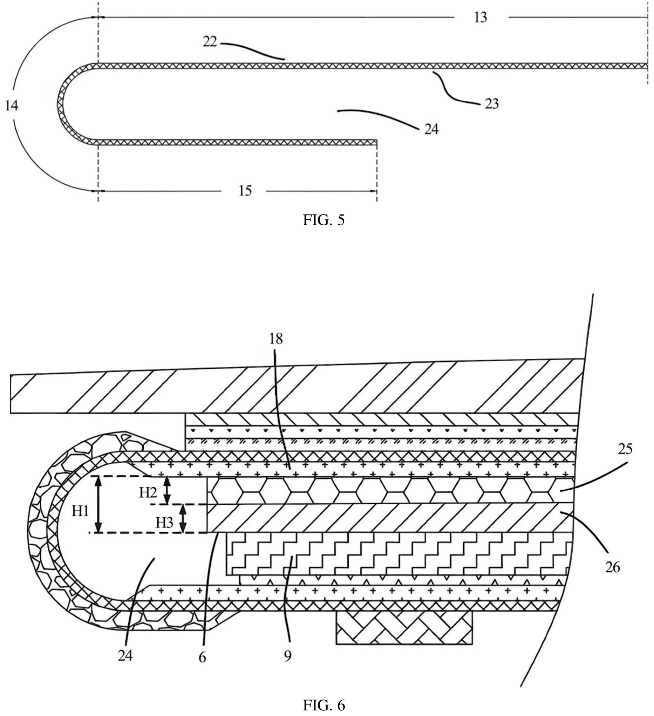

FIG. 5 is a schematic diagram of the display panel in FIG. 3. In some exemplary embodiments, as shown in FIGS. 3 and 5, the display panel 5 may include a display portion 13, a bending portion 14, and a bonding portion 15 connected sequentially. The display portion 13, the bending portion 14, and the bonding portion 15 may be integrated, the display portion 13 may have a flat plate shape, and the display portion 13 may have a light emitting side 22 and a backlight side 23. After the display portion 13 is lit, the light emitting side 22 emits light to display words or images. The bending portion 14 may be made of a flexible material, the bending portion 14 may be bent, and the bending portion 14 may be provided with metal trace or the like, and may be laid flat on a production equipment during production of the bending portion 14. The bending portion 14 may be folded to the backlight side 23 of the display portion 13 during mounting, so that the bending portion 14 is in a bending state and maintains the bending state, in which the bending portion 14 forms a nearly semicircular shape with a radius of about 0.2 mm to 0.5 mm. In this example, the radius of the semicircle formed by the bending portion 14 is about 0.25 mm, but is not limited thereto. For example, the radius of the semicircle formed by the bending portion 14 may be 0.2 mm, 0.3 mm, or 0.35 mm. The bonding portion 15 is located on the backlight side 23 of the display portion 13, the bonding portion 15 is parallel to the display portion 13, and the bonding portion 15 includes a chip mounting (Chip On Panel, COP) area and a driver integrated circuit (D-IC) area. A first gap 24 is formed between the bonding portion 15 and the display portion 13, and a member is required to support and fill the first gap 24 to support the space between the bonding portion 15 and the display portion 13.

In some exemplary embodiments, as shown in FIG. 3, the display module further includes a first circuit board 10 and a chip 11. The first circuit board 10 may be a flexible printed circuit (FPC) board, the first circuit board 10 may be welded to the near field communication structure 9, and components (not shown in the figure) may be provided on the first circuit board 10. The components (not shown in the figure) may be located on one side of the first circuit board 10. The first circuit board 10 may include a first board section 19, a first bend 21, and a second board section 20 connected sequentially. The first bend 21 may divide the first circuit board 10 into the first board section 19 and the second board section 20 in different planes, and the components (not shown in the figure) may be arranged on the second board section 20. A surface of the second board section 20 facing the display portion 5 can be welded to the near field communication structure 9, and the second board section 20 can be provided with a component area (not shown in the figure). A plurality of components (not shown in the figure) can be arranged in the component area (not shown in the figure), the plurality of components can include large components such as flash memory chips, and the components are mounted on the first circuit board 10 by surface mount technology (SMT). The first board section 19 may extend to a surface of the bonding portion 15 away from the display portion 13, and the bonding portion 15 and the driver integrated circuit area of the bonding portion 15 are bonded to form an electrical connection between the first board section 19 and the bonding portion 15. The chip 11 is located on the surface of the bonding portion 15 away from the display portion 13, and the chip 11 and the chip mounting area of the bonding portion 15 are bonded to form an electrical connection between the chip 11 and the bonding portion 15. Further, an orthographic projection of the chip 11 on the display portion 13 is located within the orthographic projection of the near field communication structure 9 on the display portion 13.

In some exemplary embodiments, as shown in FIG. 3, the display module further includes a cover plate 1, a curable optical adhesive 2, a polarizer 3, and an encapsulation layer 4, and the cover plate 1. The curable optical adhesive 2, the polarizer 3 and the encapsulation layer 4 are located on a light emitting side of the display portion 13. The encapsulation layer 4, the polarizer 3, the curable optical adhesive 2, and the cover plate 1 are sequentially stacked in a direction away from the display portion 13, and the encapsulation layer 4, the polarizer 3, the curable optical adhesive 2, and the cover plate 1 can all transmit light emitted from the display portion 13. Both the encapsulation layer 4 and the cover plate 1 can protect the display portion 13, and the polarizer 3 can reduce the influence of external light emission on image display of the display portion 13.

In some exemplary embodiments, as shown in FIGS. 3 and 5, the display module further includes a back film layer (Bottom Film, BF) 6. The back film layer 6 may be provided on the display panel 5, and according to different positions, the back film layer 6 may be divided into a first back film layer 17 located on a surface of the bonding portion 15 facing the near field communication structure 9 and a second back film layer 18 located on a surface of the backlight side of the display portion 13. In the case that the bending portion 14 is in a bending state, the first back film layer 17 cover a surface of the bonding portion 15 facing the display portion 13, and the second back film layer 18 cover a surface of the display portion 13 close to the bonding portion 15. The first back film layer 17 and the second back film layer 18 can be prepared on the display panel 5 during production of the display panel 5. When the first back film layer 17 and the second back film layer 18 are prepared on the display panel 5, the bending portion 14 is laid flat on the production equipment, and the first back film layer 17 and the second back film layer 18 are arranged in place at one time. The first back film layer 17 and the second back film layer 18 also fill part of the space in the first gap 24. In addition, the display module further includes a protective adhesive layer (Metal Coating Layer, MCL) 12, and the protective adhesive layer 12 covers at least a side of the bending portion 14 facing away from the near field communication structure 9. The protective adhesive layer 12 also covers a portion of a surface of the bonding portion 15 away from the near field communication structure 9, and the protective adhesive layer 12 can protect the members covered by it.

In an exemplary embodiment, as shown in FIGS. 3, 4 and 5, one end of the near field communication structure 9 is inserted into the first gap 24 and is located between the first back film layer 17 and the second back film layer 18, and the near field communication structure 9 may be configured to be adhered to the first back film layer 17. Compared with the display module shown in FIG. 1, the display module of the present example omits the bending spacer 8, the bending spacer 8 is replaced with the near field communication structure 9, and the near field communication structure 9 is filled between the display portion 13 and the bonding portion 15. A surface of the near field communication structure 9 facing the first back film layer 17 may be provided with a double-sided adhesive 16 for adhering, and the double-sided adhesive 16 may be AD adhesive, that is, acrylic hot melt adhesive. The double-sided adhesive 16 can be pre-applied on the near field communication structure 9 before the near field communication structure 9 and the display panel 5 are assembled. When the near field communication structure 9 and the display panel 5 are assembled, the double-sided adhesive 16 and the near field communication structure 9 are integrally fed, which can reduce the preparation steps, effectively optimize the production line process, and eliminates the need for manual attachment of the double-sided adhesive 16. In an exemplary embodiment, a thickness of the double-sided adhesive 16 may be configured to be 0.02 mm to 0.05 mm, and the thickness of the double-sided adhesive 16 may be a dimension of the double-sided adhesive 16 in the direction perpendicular to the display portion 15. In this example, the thickness of the double-sided adhesive 16 may be 0.03 mm, but is not limited thereto. For example, the thickness of the double-sided adhesive 16 may be 0.04 mm. For another example, the thickness of the double-sided adhesive 16 may be 0.02 mm, and for another example, the thickness of the double-sided adhesive 16 may be 0.05 mm. The orthographic projection of the bonding portion 15 on the display portion 13 may be provided as a second projection A, and the orthographic projection of the near field communication structure 9 on the display portion 13 may be provided as a first projection B. The first projection B is configured to partially overlap with the second projection A, a part of the first projection B does not overlap with the second projection A, a part of the second projection A does not overlap with the first projection B, and the overlapping portion of the first projection B and the second projection A may be a third projection C. An orthographic projection of the double-sided adhesive 16 on the display portion 13 may be located within the third projection C, and the orthographic projection of the chip 11 on the display portion 13 may also be located within the third projection C. In an exemplary embodiment, a projection area where the second projection A and the first projection B overlap is an area of the third projection C, and the area of the third projection C may be greater than two-thirds of the area of the second projection A. In this example, the area of the third projection C is about four-fifths of the projection area of the second projection A, but is not limited thereto. For example, the area of the third projection C is about seven-ninths of the area of the second projection A, and for another example, the area of the third projection C is about three-quarters of the area of the second projection A. In an exemplary embodiment, the projection area of the orthographic projection of the near field communication structure 9 on the display portion 13 is the area of the first projection B. The area of the first projection B is not less than two-thirds of an area of the display portion 13, and the area of the display portion 13 is an area occupied by the display portion 13 in a plane on which the display portion 13 is located. In this example, the area of the first projection B may be four-fifths of the area of the display portion 13, but is not limited thereto. For example, the area of the first projection B is about two-thirds of the area of the display portion 13, and for another example, the area of the first projection B is about seven-tenths of the area of the display portion 13.

FIG. 6 is a partial schematic diagram of FIG. 3. In some exemplary embodiments, as shown in FIGS. 3, 5, and 6, the display module further includes a composite film 7, the composite film 7 is located on the backlight side 23 of the display portion 13, and the composite film 7 may be disposed between the near field communication structure 9 and the display portion 13. The composite film 7 may be sandwiched between the second back film layer 18 and the near field communication structure 9, and the near field communication structure 9 may be adhered to the second back film layer 18 and the near field communication structure 9, respectively. One end of the composite film 7 is also inserted into the first gap 24, and the orthographic projection of the near field communication structure 9 on the display portion 13 may all be located within an orthographic projection of the composite film 7 on the display portion 13, so that an orthographic projection of the bonding portion 15 on the display portion 13 may overlap with the orthographic projection of the composite film 7 on the display portion 13. In some exemplary embodiments, a thickness of the composite film 7 may be H1, and H1 may be less than 0.16 mm. The thickness of the composite film 7 in the present example may range from 0.06 mm to 0.12 mm, that is, 0.06 mm ≤ H1 ≤ 0.12 mm, and the thickness of the composite film 7 may be the dimension of the composite film 7 in the direction perpendicular to the display portion 13. In the present example, the thickness of the composite film 7 may be 0.09 mm, that is, H1 = 0.09 mm, and compared to the thickness of the composite film 7 in the relevant display module, which may be 0.16 mm, the thickness of the composite film 7 in the present example is smaller, providing sufficient space in the first gap 24 for the near field communication structure 9 and the double-sided adhesive 16. In an exemplary embodiment, the composite film 7 includes a first film layer 25 and a mesh adhesive 26 stacked in a direction perpendicular to the display portion 13, and the number of layers of the first film layer 25 and the mesh adhesive 26 is not limited to one layer, but may be multiple layers. A material of the first film layer 25 may be graphite, foam glue, or polyimide, a thickness of the first film layer 25 may be configured as H2, a value of H2 may be 0.05 mm to 0.07 mm, a thickness of the mesh adhesive 26 may be configured as H3, and a value of H3 may be 0.02 mm to 0.04 mm.

In an exemplary embodiment, as shown in FIG. 6, the thickness of the composite film 7 may be 0.09 mm, that is, H1 = 0.09 mm, and the material of the first film layer 25 may be foam glue. The first film layer 25 forms a foam glue layer, a thickness of the foam glue layer is H2, and a thickness of the mesh glue 26 may be configured as H3, wherein H2 = 0.06 mm and H3 = 0.03 mm.

In an exemplary embodiment, as shown in FIG. 6, the thickness of the composite film 7 may be 0.09 mm, that is, H1 = 0.09 mm, and the material of the first film layer 25 may be foam glue. The first film layer 25 forms a foam glue layer, a thickness of the foam glue layer is H2, and a thickness of the mesh glue 26 may be configured as H3, wherein H2 = 0.05 mm and H3 = 0.04 mm.

In an exemplary embodiment, as shown in FIG. 6, the thickness of the composite film 7 may be 0.09 mm, that is, H1 = 0.09 mm, the material of the first film layer 25 may be polyimide, and the first film layer 25 forms a polyimide layer. A thickness of the polyimide layer is H2, and a thickness of the mesh glue 26 may be configured as H3, wherein H2 = 0.06 mm and H3 = 0.03 mm.

In an exemplary embodiment, as shown in FIG. 6, the thickness of the composite film 7 may be 0.09 mm, that is, H1 = 0.09 mm, the material of the first film layer 25 may be polyimide, and the first film layer 25 forms a polyimide layer. A thickness of the polyimide layer is H2, and a thickness of the mesh glue 26 may be configured as H3, wherein H2 = 0.05 mm and H3 = 0.04 mm.

In an exemplary embodiment, as shown in FIG. 6, the thickness of the composite film 7 may be 0.09 mm, that is, H1 = 0.09 mm, the material of the first film layer 25 may be graphite sheet, and the first film layer 25 forms a graphite layer. A thickness of the graphite layer is H2, and a thickness of the mesh glue 26 may be configured as H3, wherein H2 = 0.06 mm and H3 = 0.03 mm.

In an exemplary embodiment, as shown in FIG. 6, the thickness of the composite film 7 may be 0.09 mm, that is, H1 = 0.09 mm, the material of the first film layer 25 may be graphite sheet, and the first film layer 25 forms a graphite layer. A thickness of the graphite layer is H2, and a thickness of the mesh glue 26 may be configured as H3, wherein H2 = 0.05 mm and H3 = 0.04 mm.

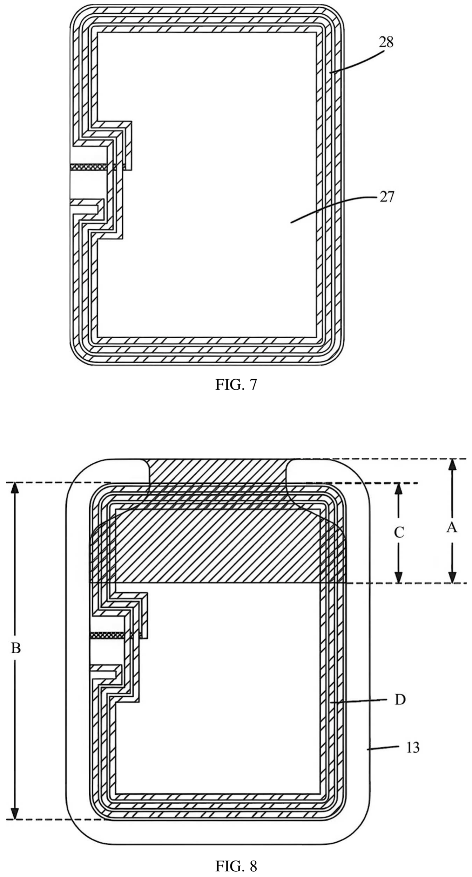

FIG. 7 is a schematic diagram of a near field communication structure according to an exemplary embodiment of the present disclosure. In some exemplary embodiments, as shown in FIG. 7, the near field communication structure 9 may include a ferrite plate 27 and a first trace 28 disposed on the ferrite plate 27. The ferrite plate 27 may have a rectangular plate shape, but is not limited thereto. For example, the ferrite plate 27 may be a parallelogram plate, a trapezoidal plate, a circular plate, or an irregular pattern plate or the like. The first trace 28 is arranged along an edge of the ferrite plate 27 and encloses in a ring shape, but the location of the first trace 28 is not limited to the edge of the ferrite plate 27, and the first trace 28 may be located at other locations of the ferrite plate 27.

FIG. 8 is a schematic projection diagram of the near field communication structure in FIG. 7 on the display portion. In some exemplary embodiments, as shown in FIGS. 3, 7, and 8, an orthographic projection of the ferrite plate 27 on the display portion 13 is configured to be the same as the orthographic projection of the near field communication structure 9 on the display portion 13, both of which are first projections B. The orthographic projection of the bonding portion 15 on the display portion 13 may be provided as a second projection A. The first projection B partially overlaps with the second projection A, there is a non-overlapping portion of both the first projection B and the second projection A, and the overlapping portion of the first projection B and the second projection A may be a third projection C. An orthographic projection of the first trace 28 on the display portion 13 may be a fourth projection D, and the orthographic projection of the first trace 28 on the display portion 13 may overlap with the orthographic projection of the bonding portion 15 on the display portion 13, that is, there is an overlapping portion between the second projection A and the fourth projection D.

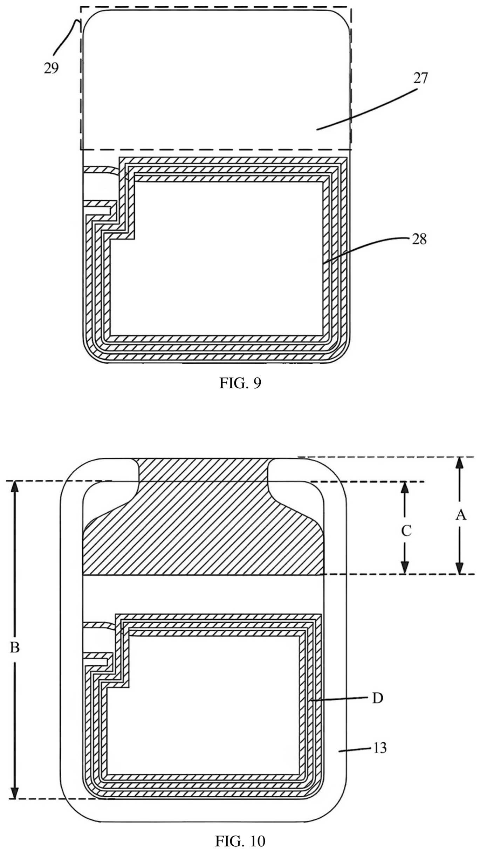

FIG. 9 is a schematic diagram of another near field communication structure according to an exemplary embodiment of the present disclosure. In some exemplary embodiments, as shown in FIG. 9, the near field communication structure 9 may include a ferrite plate 27 and a first trace 28 disposed on the ferrite plate 27. The ferrite plate 27 may have a rectangular plate shape, but is not limited thereto. For example, the ferrite plate 27 may be a parallelogram plate, a trapezoidal plate, a circular plate, or an irregular pattern plate or the like. The first trace 28 encloses in a ring shape, and the ferrite plate 27 has a first region 29 where the first trace 28 is not arranged.

FIG. 10 is a schematic projection diagram of the near field communication structure in FIG. 9 on the display portion. In some exemplary embodiments, as shown in FIGS. 3, 9 and 10, the first region 29 of the ferrite plate 27 corresponds to the bonding portion in a direction perpendicular to the display portion 13, and an orthographic projection of the ferrite plate 27 on the display portion 13 is configured to be the same as the orthographic projection of the near field communication structure 9 on the display portion 13, both of which are first projections B. The orthographic projection of the bonding portion 15 on the display portion 13 may be provided as a second projection A. The first projection B partially overlaps with the second projection A, there is a non-overlapping portion of both the first projection B and the second projection A, and the overlapping portion of the first projection B and the second projection A may be a third projection C. An orthographic projection of the first trace 28 on the display portion 13 may be a fourth projection D, and the orthographic projection of the first trace 28 on the display portion 13 may not overlap with the orthographic projection of the bonding portion 15 on the display portion 13, that is, the second projection A does not overlap with the fourth projection D.

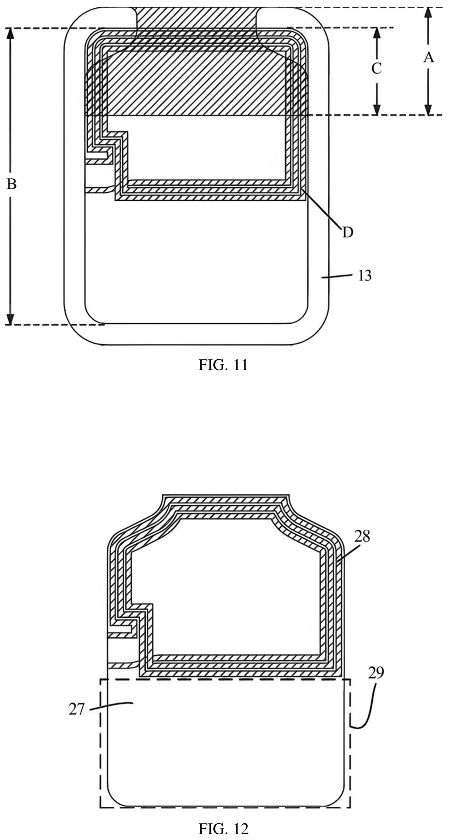

FIG. 11 is another schematic projection diagram of the near field communication structure in FIG. 9 on the display portion. In some exemplary embodiments, as shown in FIGS. 3, 9 and 11, the first region 29 of the ferrite plate 27 is staggered from the bonding portion in a direction perpendicular to the display portion 13. An orthographic projection of the ferrite plate 27 on the display portion 13 is configured to be the same as the orthographic projection of the near field communication structure 9 on the display portion 13, both of which are first projections B. The orthographic projection of the bonding portion 15 on the display portion 13 may be provided as a second projection A. The first projection B partially overlaps with the second projection A, there is a non-overlapping portion of both the first projection B and the second projection A, and the overlapping portion of the first projection B and the second projection A may be a third projection C. An orthographic projection of the first trace 28 on the display portion 13 may be a fourth projection D, and the orthographic projection of the first trace 28 on the display portion 13 may overlap with the orthographic projection of the bonding portion 15 on the display portion 13, that is, there is an overlapping portion between the second projection A and the fourth projection D.

FIG. 12 is a schematic diagram of another near field communication structure according to an exemplary embodiment of the present disclosure. In some exemplary embodiments, as shown in FIG. 12, the near field communication structure 9 may include a ferrite plate 27 and a first trace 28 disposed on the ferrite plate 27. The ferrite plate 27 may be an irregular pattern plate. The first trace 28 encloses in a ring shape, and the ferrite plate 27 has a first region 29 where the first trace 28 is not arranged.

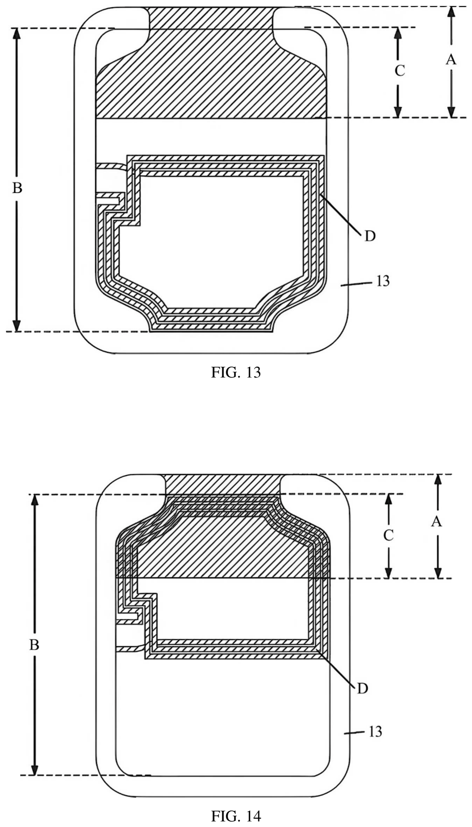

FIG. 13 is a schematic projection diagram of the near field communication structure in FIG. 12 on the display portion. In some exemplary embodiments, as shown in FIGS. 3, 12 and 13, the first region 29 of the ferrite plate 27 corresponds to the bonding portion 15 in a direction perpendicular to the display portion 13. An orthographic projection of the ferrite plate 27 on the display portion 13 is the same as the orthographic projection of the near field communication structure 9 on the display portion 13, both of which are first projections B. The orthographic projection of the bonding portion 15 on the display portion 13 may be provided as a second projection A. The first projection B partially overlaps with the second projection A, there is a non-overlapping portion of both the first projection B and the second projection A, and the overlapping portion of the first projection B and the second projection A may be a third projection C. An orthographic projection of the first trace 28 on the display portion 13 may be a fourth projection D, and the orthographic projection of the first trace 28 on the display portion 13 may not overlap with the projection of the bonding portion 15 on the display portion 13, that is, the second projection A does not overlap with the fourth projection D.

FIG. 14 is another schematic projection diagram of the near field communication structure in FIG. 12 on the display portion. In some exemplary embodiments, as shown in FIGS. 3, 12 and 14, the first region 29 of the ferrite plate 27 is staggered from the bonding portion 15 in a direction perpendicular to the display portion 13. An orthographic projection of the ferrite plate 27 on the display portion 13 is configured to be the same as the orthographic projection of the near field communication structure 9 on the display portion 13, both of which are first projections B. The orthographic projection of the bonding portion 15 on the display portion 13 may be provided as a second projection A. The first projection B partially overlaps with the second projection A, there is a non-overlapping portion of both the first projection B and the second projection A, and the overlapping portion of the first projection B and the second projection A may be a third projection C. An orthographic projection of the first trace 28 on the display portion 13 may be a fourth projection D, and the orthographic projection of the first trace 28 on the display portion 13 may overlap with the orthographic projection of the bonding portion 15 on the display portion 13, that is, there is an overlapping portion between the second projection A and the fourth projection D.

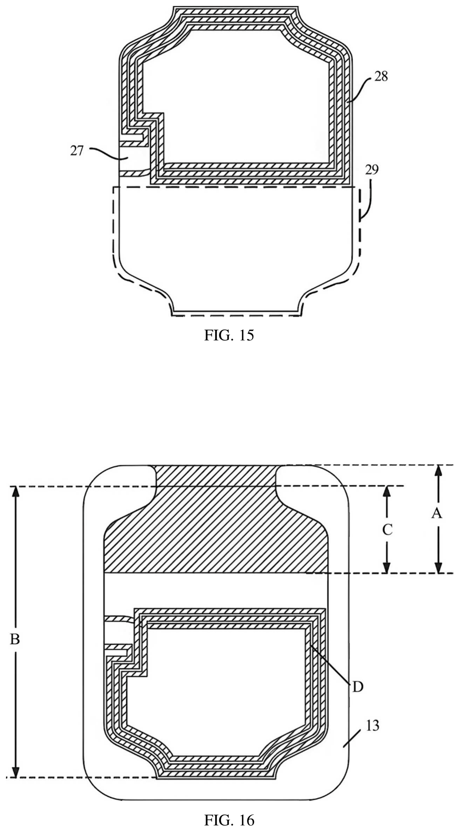

FIG. 15 is a schematic diagram of another near field communication structure according to an exemplary embodiment of the present disclosure. In some exemplary embodiments, as shown in FIG. 15, the near field communication structure 9 may include a ferrite plate 27 and a first trace 28 disposed on the ferrite plate 27. The ferrite plate 27 may be an irregular pattern plate. The first trace 28 encloses in a ring shape, and the ferrite plate 27 has a first region 29 where the first trace 28 is not arranged.

FIG. 16 is a schematic projection diagram of the near field communication structure in FIG. 15 on the display portion. In some exemplary embodiments, as shown in FIGS. 3, 15 and 16, the first region 29 of the ferrite plate 27 corresponds to the bonding portion 15 in a direction perpendicular to the display portion 13. An orthographic projection of the ferrite plate 27 on the display portion 13 is configured to be the same as the orthographic projection of the near field communication structure 9 on the display portion 13, both of which are first projections B. The orthographic projection of the bonding portion 15 on the display portion 13 may be provided as a second projection A. The first projection B partially overlaps with the second projection A, there is a non-overlapping portion of both the first projection B and the second projection A, and the overlapping portion of the first projection B and the second projection A may be a third projection C. An orthographic projection of the first trace 28 on the display portion 13 may be a fourth projection D, and the orthographic projection of the first trace 28 on the display portion 13 may not overlap with the projection of the bonding portion 15 on the display portion 13, that is, the second projection A does not overlap with the fourth projection D.

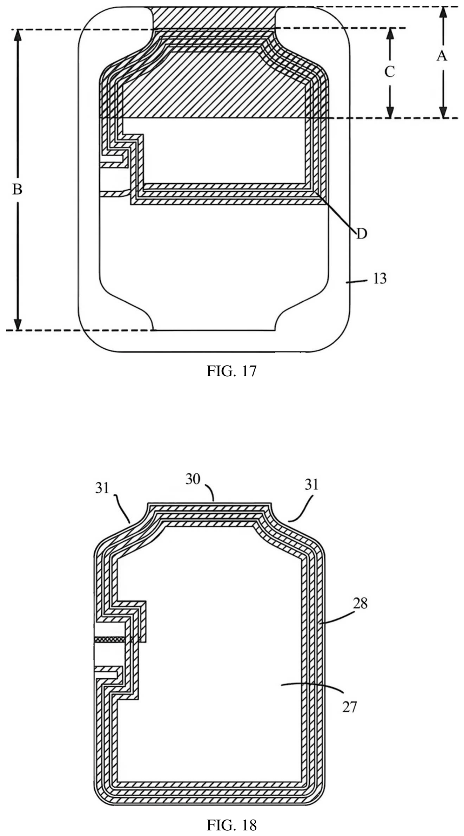

FIG. 17 is another schematic projection diagram of the near field communication structure in FIG. 15 on the display portion. In some exemplary embodiments, as shown in FIGS. 3, 15 and 17, the first region 29 of the ferrite plate 27 is staggered from the bonding portion 15 in a direction perpendicular to the display portion 13. An orthographic projection of the ferrite plate 27 on the display portion 13 is configured to be the same as the orthographic projection of the near field communication structure 9 on the display portion 13, both of which are first projections B. The orthographic projection of the bonding portion 15 on the display portion 13 may be provided as a second projection A. The first projection B partially overlaps with the second projection A, there is a non-overlapping portion of both the first projection B and the second projection A, and the overlapping portion of the first projection B and the second projection A may be a third projection C. An orthographic projection of the first trace 28 on the display portion 13 may be a fourth projection D, and the orthographic projection of the first trace 28 on the display portion 13 may overlap with the orthographic projection of the bonding portion 15 on the display portion 13, that is, there is an overlapping portion between the second projection A and the fourth projection D.

FIG. 18 is a schematic diagram of another near field communication structure according to an exemplary embodiment of the present disclosure. In some exemplary embodiments, as shown in FIG. 18, the near field communication structure 9 may include a ferrite plate 27 which is an irregular pattern plate and a first trace 28 disposed on the ferrite plate 27. A circumferential edge of the ferrite plate 27 includes a first edge 30, and two notches 31 may be provided on the first edge 30, so that the ferrite plate 27 forms an irregular shape. The first trace 28 is arranged along the edge of the ferrite plate 27 and encloses in a ring shape.

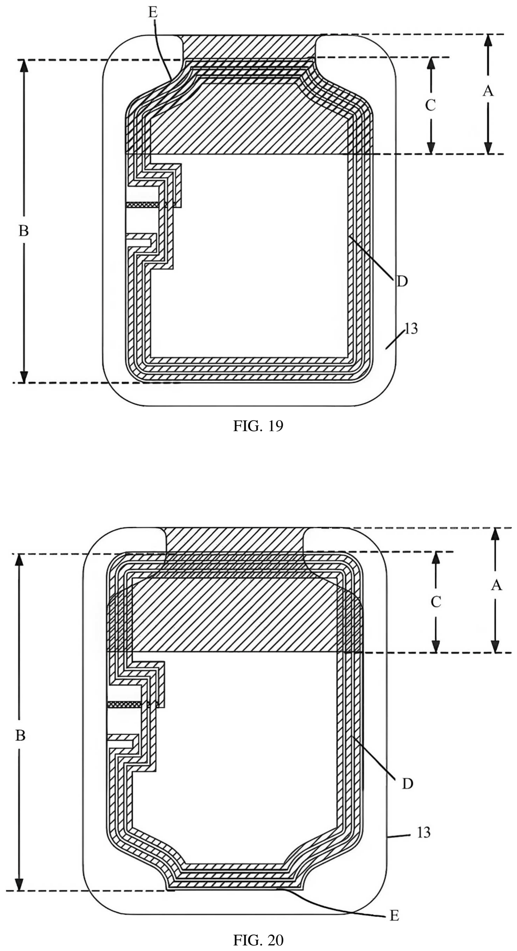

FIG. 19 is a schematic projection diagram of the near field communication structure in FIG. 18 on the display portion. In some exemplary embodiments, as shown in FIGS. 3, 18, and 19, the first edge 30 of the ferrite plate 27 is located on a side of the ferrite plate 27 close to a bending portion 14. An orthographic projection of the ferrite plate 27 on a display portion 13 is configured to be the same as the orthographic projection of the near field communication structure 9 on the display portion 13, both of which are first projections B. An orthographic projection of the bonding portion 15 on the display portion 13 may be provided as a second projection A. The first projection B may partially overlap with the second projection A, there is a non-overlapping portion of both the first projection B and the second projection A, and the overlapping portion of the first projection B and the second projection A may be a third projection C. An orthographic projection of the first trace 28 on the display portion 13 may be a fourth projection D, and the orthographic projection of the first trace 28 on the display portion 13 may overlap with the projection of the bonding portion 15 on the display portion 13, that is, the second projection A overlaps with the fourth projection D. An orthographic projection of the first edge 30 on the display portion 13 may be a fifth projection E, and the fifth projection E is located within the second projection A.

FIG. 20 is another schematic projection diagram of the near field communication structure in FIG. 18 on the display portion. In some exemplary embodiments, as shown in FIGS. 3, 18, and 20, the first edge 30 of the ferrite plate 27 is located on a side of the ferrite plate 27 away from the bending portion 14. An orthographic projection of the ferrite plate 27 on the display portion 13 is configured to be the same as the orthographic projection of the near field communication structure 9 on the display portion 13, both of which are first projections B. The orthographic projection of the bonding portion 15 on the display portion 13 may be provided as a second projection A. The first projection B may partially overlap with the second projection A, there is a non-overlapping portion of both the first projection B and the second projection A, and the overlapping portion of the first projection B and the second projection A may be a third projection C. An orthographic projection of the first trace 28 on the display portion 13 may be a fourth projection D, and the orthographic projection of the first trace 28 on the display portion 13 may overlap with the orthographic projection of the bonding portion 15 on the display portion 13, that is, there is an overlapping portion between the second projection A and the fourth projection D.

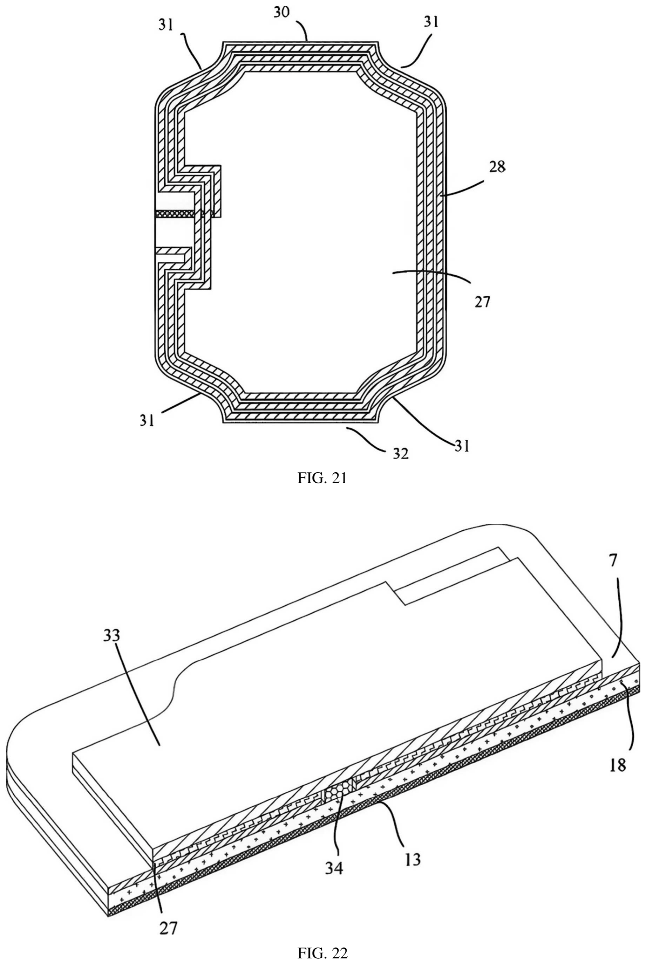

FIG. 21 is a schematic diagram of another near field communication structure according to an exemplary embodiment of the present disclosure. In some exemplary embodiments, as shown in FIG. 21, the near field communication structure 9 may include a ferrite plate 27 which is an irregular pattern plate and a first trace 28 disposed on the ferrite plate 27. A circumferential edge of the ferrite plate 27 includes a first edge 30 and a second edge 32, and two notches 31 may be provided on both the first edge 30 and the second edge 32, so that the ferrite plate 27 forms an irregular shape. The first trace 28 is arranged along the edge of the ferrite plate 27 and encloses in a ring shape.

FIG. 22 is a schematic cross-sectional diagram of another display module according to an exemplary embodiment of the present disclosure. In some exemplary embodiments, as shown in FIGS. 3 and 22, the near field communication structure 9 may include a ferrite plate 27 in a plate shape and a copper foil 33, and the ferrite plate 27 and the copper foil 33 may be stacked in a direction perpendicular to the display portion 13. The ferrite plate 27 is located on a side of the copper foil 33 facing the composite film 7, and the ferrite plate 27 may be adhered to the composite film 7 and the copper foil 33, respectively. The display portion 13, the second back film layer 18, the composite film 7, the ferrite plate 27, and the copper foil 33 are stacked sequentially in a direction perpendicular to the display portion 13.

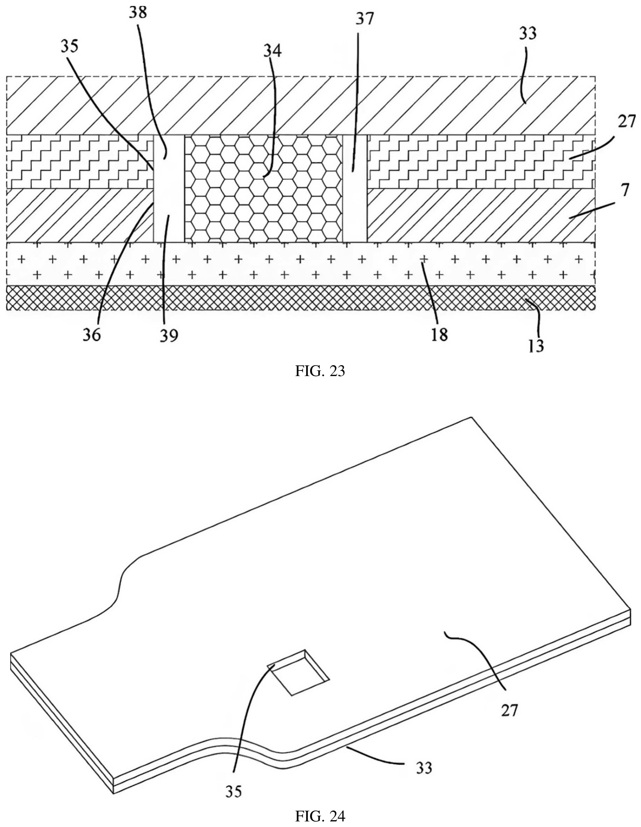

FIG. 23 is a partial schematic cross-sectional diagram of the display module in FIG. 22, and FIG. 24 is a schematic diagram of the ferrite plate in FIG. 22. In some exemplary embodiments, as shown in FIG. 3, 22, 23 and 24, the display module further includes a conductive member 34 that can conduct electricity, and the conductive member 34 can penetrate the composite film 7 and the ferrite plate 27, and can realize the connection between the copper foil 33 and the second back film layer 18. The copper foil 33 can be used as a ground terminal by connecting to a housing or in other forms, and the second back film layer 18 is connected to the copper foil 33 via the conductive member 34, realizing grounding of the display portion 13.

In some exemplary embodiments, as shown in FIGS. 3, 22, 23 and 24, the ferrite plate 27 may be provided with a first through hole 35 that penetrates the ferrite plate 27 in a direction perpendicular to the display portion 13. The first through hole 35 may be a rectangular hole, but is not limited thereto. For example, the first through hole 35 may be a regular hole such as a circular hole, a triangular hole, or a trapezoidal hole, and the first through hole 35 may also be an irregular hole. The composite film 7 may be provided with a second through hole 36 that penetrates the composite film 7 in a direction perpendicular to the display portion 13, and the hole pattern and size of the second through hole 36 are the same as those of the first through hole 35. The second through hole 36 and the first through hole 35 in this example are both rectangular holes, but not limited thereto. For example, the hole patterns of the second through hole 36 and the first through hole 35 are different, and for another example, the hole patterns of the second through hole 36 and the first through hole 35 are the same, but the size is not the same. One end of the first through hole 35 extends to the copper foil 33, the other end of the first through hole 35 is in communication with a first end of the second through hole 36, and a second end of the second through hole 36 extends to the second back film layer 18. In this way, the second through hole 36 and the first through hole 35 are disposed correspondingly in a direction perpendicular to the display portion 15, and the second through hole 36 and the first through hole 35 together constitute an accommodation cavity 37, so that a cross-section of the accommodation cavity 37 in a plane parallel to the display portion 13 is rectangular.

In some exemplary embodiments, as shown in FIGS. 3, 22, 23 and 24, a material of the conductive member 34 may be conductive foam or conductive double-sided adhesive, and the conductive member 34 has conductivity and certain flexibility. In this example, the material of the conductive member 34 is conductive foam, but is not limited thereto. For example, the material of the conductive member 34 may be other flexible and conductive materials except for the conductive foam and the conductive double-sided adhesive. A cross-section of the conductive member 34 in the plane parallel to the display portion 13 may be rectangular, so that an appearance of the conductive member 34 matches the hole patterns of the second through hole 36 and the first through hole 35, but is not limited thereto. For example, the cross-section of the conductive member 34 in the plane parallel to the display portion 13 may be circular, trapezoidal, rhombic, triangular or irregular pattern, and both the second through hole 36 and the first through hole 35 are provided as corresponding circular holes, trapezoidal holes, rhombic holes, triangular holes or irregular pattern holes corresponding to the conductive member 34. The cross-section of the conductive member 34 in a plane parallel to the display portion 13 may be rectangular, and a minimum area of the cross-section may be S, where S ≥ 5 mm². In this example, S = 6 mm², but is not limited thereto. For example, the minimum area S of the cross-section of the conductive member 34 may be 5 mm², for another example, the minimum area S of the cross-section of the conductive member 34 may be 6.5 mm², and for another example, the minimum area S of the cross-section of the conductive member 34 may be 8 mm².

In some exemplary embodiments, as shown in FIGS. 3, 22, 23 and 24, the conductive member 34 is located in the accommodation cavity 37, and the conductive member 34 penetrates the second through hole 36 and the first through hole 35. One end of the conductive member 34 in the direction perpendicular to the display portion 13 abuts against the copper foil 33, and the other end of the conductive member 34 in the direction perpendicular to the display portion 13 abuts against the second back film layer 18. A minimum area of a cross-section of the conductive member 34 in a plane parallel to the display portion 13 may be greater than or equal to 5 mm², so that a contact area between the conductive member 34 and the second back film layer 18 is greater than or equal to 5 mm², and a contact area between the conductive member 34 and the copper foil 33 is greater than or equal to 5 mm². It can be seen that a grounding area affected by the conductive member 34 is greater than or equal to 5 mm². As a result, the electrostatic of the display portion 15 is guided to the conductive member 34 through the second back film layer 18, and then guided to the copper foil 33 by the conductive member 34. The conductive member 34 penetrates the first through-hole 35, and an outer wall of the conductive member 34 is spaced apart from an inner side wall of the first through-hole 35, that is, there is a second gap 38 between the outer wall of the conductive member 34 and the inner side wall of the first through-hole 35. The second gap 38 may be a gap surrounding the conductive member 34 so that the conductive member 34 is not in contact with the inner side wall of the first through-hole 35. A minimum distance between the outer wall of the conductive member 34 and the inner side wall of the first through hole 35 is about 0.3 mm to 0.7 mm. In this example, the minimum distance between the outer wall of the conductive member 34 and the inner side wall of the first through hole 35 may be 0.5 mm, but is not limited thereto. For example, the minimum distance between the outer wall of the conductive member 34 and the inner side wall of the first through hole 35 may be 0.4 mm, and for another example, the minimum distance between the outer wall of the conductive member 34 and the inner side wall of the first through hole 35 may be 0.6 mm. The conductive member 34 penetrates the second through-hole 36, and the outer wall of the conductive member 34 is spaced apart from an inner side wall of the second through-hole 36, that is, there is a third gap 39 between the outer wall of the conductive member 34 and the inner side wall of the second through-hole 36. The third gap 39 may be a gap surrounding the conductive member 34 so that the conductive member 34 is not in contact with the inner side wall of the second through-hole 36. A minimum distance between the outer wall of the conductive member 34 and the inner side wall of the second through hole 36 is about 0.3 mm to 0.7 mm. In this example, the minimum distance between the outer wall of the conductive member 34 and the inner side wall of the second through hole 36 may be 0.5 mm, but is not limited thereto. For example, the minimum distance between the outer wall of the conductive member 34 and the inner side wall of the second through hole 36 may be 0.4 mm, and for another example, the minimum distance between the outer wall of the conductive member 34 and the inner side wall of the second through hole 36 may be 0.6 mm.

In some exemplary embodiments, as shown in FIGS. 3, 22, 23 and 24, one conductive member 34 may be provided, and one containment cavity 37 may be provided, but it is not limited to this. In some exemplary embodiments, a plurality of conductive members 34 may be provided, a plurality of accommodation cavities 37 may be provided, and the conductive members 34 and the accommodation cavities 37 are arranged in one-to-one correspondence. For example, the ferrite plate 27 may be provided with two first through holes 35, the composite film 7 may be provided with two second through holes 36 corresponding to the first through holes 35, forming two accommodation cavities 37, and each of the two accommodation cavities 37 is provided with one conductive member 34. For another example, the ferrite plate 27 may be provided with four first through holes 35, the composite film 7 may be provided with four second through holes 36 corresponding to the first through holes 35, forming four accommodation cavities 37, and each of the four accommodation cavities 37 is provided with one conductive member 34. The plurality of conductive members 34 can contact the copper foil 33 and the second back film layer 18, and the plurality of conductive members 34 can effectively improve the electrostatic field resistance and electrostatic protection capabilities of the display module.

In some exemplary embodiments, a mounting method for assembling a display module as shown in FIG. 3 mainly has three steps, and the three steps include bonding of the display panel 5, assembling of the composite film 7 and mounting of the near field communication structure 9, and bending. First, the bending portion 14 of the display panel 5 is not in a bending state, the bending portion 14 is not folded, and in this state, the adhesion of the back film 6 and the protective adhesive layer 12 is completed, and the bonding portion 15 of the display panel 5 and the first circuit board 10 are bonded. Next, the composite film 7 is attached to the display portion 13 of the display panel 5, and the composite film 7 is attached on the backlight side of the display portion 13. Then, the near field communication structure 9 is mounted, and the near field communication structure 9 is aligned and adhered to the composite film 7. The double-sided adhesive 16 has been pre-mounted on the near field communication structure 9, and the double-sided adhesive 16 and the near field communication structure 9 are integrally fed. Finally, the bending portion 14 is folded so that the bending portion 14 is in a bending state, the double-sided adhesive 16 is aligned and adhered to the back film on the bonding area 15, and then the near field communication structure 9 and the first circuit board 10 are welded to complete the assembly of the display module. Further, as shown in FIG. 3, the cover plate 1, the curable optical adhesive 2, the polarizer 3, and the encapsulation layer 4 may be mounted on the display module. In the first step of mounting the display module, that is, before bonding the display panel 5, the encapsulation layer 4, the polarizer 3, the curable optical adhesive 2, and the cover plate 1 need to be mounted in alignment to the display portion 13 of the display panel 5 sequentially.

In some exemplary embodiments, a display device includes the above-described display module, and the display device may be an OLED display device. The display device provided by the embodiment of the present disclosure can be applied to an electronic device, which may be a mobile phone, a tablet computer, a television, a display, a notebook computer, a digital photo frame, a navigator, an in-vehicle display, or any product or component having a display function such as a wearable device, for example, a smart watch, a smart bracelet, smart glasses, a smart headset, a smart clothing, a head-mounted display, and the like. In this example, the display device is a mobile phone, and by increasing the space occupied by the near field communication structure 9, the signal quantity of the near field communication structure 9 can be ensured, while the structure can be simplified.

In combination with the above embodiments, the display module ensures the signal quantity of the near field communication structure 9 by increasing the space occupied by the near field communication structure 9, so that the performance of the display device in the 12 o'clock and 6 o'clock directions is close to each other. The display module reduces the thickness of the composite film, replaces the bending spacer with the double-sided adhesive 16, and then extends the near field communication structure 9 to increase the area of the near field communication structure 9, thereby improving the performance of the near field communication structure 9. The display module can achieve constant overall maximum stacking thickness, but the signal of the near field communication structure 9 is greatly improved, and the elimination of bending spacer can save material and labor costs. The double-sided adhesive 16 and the near field communication structure 9 is integrally loaded, effectively optimizing the production line process without additional manual attachment of the double-sided adhesive 16. An electrostatic field optimization measure is introduced into the display module, and the copper foil and the display panel are grounded with the conductive member by means of creating holes or notches in the near field communication structure 9 and the composite film. The grounding area of a single conductive member 34 is greater than or equal to 5 mm², and the number of the conductive members 34 is at least one, which effectively improves the electrostatic field resistance and electrostatic protection capabilities of the display module.

Those of ordinary skills in the art may understand that all or some of acts in the methods disclosed above, systems, functional modules or units in apparatuses may be implemented as software, firmware, hardware, and an appropriate combination thereof. In a hardware implementation, division of the function modules/units mentioned in the above description is not always corresponding to division of physical components. For example, a physical component may have multiple functions, or a function or an act may be executed by several physical components in cooperation. Some components or all components may be implemented as software executed by a processor such as a digital signal processor or a microprocessor, or implemented as hardware, or implemented as an integrated circuit such as an application specific integrated circuit. Such software may be distributed on a computer readable medium, and the computer readable medium may include a computer storage medium (or a non-transitory medium) and a communication medium (or a transitory medium). As known to those of ordinary skills in the art, a term computer storage medium includes volatile and nonvolatile, and removable and irremovable media implemented in any method or technology for storing information (for example, a computer readable instruction, a data structure, a program module, or other data). The computer storage medium includes, but is not limited to, a Random Access Memory (RAM), a Read-Only Memory (ROM), an Electrically Erasable Programmable ROM (EEPROM), a flash memory or other memory technologies, a Compact Disc Read-Only Memory (CD-ROM), a Digital Video Disk (DVD) or other optical discs, a cassette, a magnetic tape, a disk memory or other magnetic storage apparatus, or any other medium configurable to store expected information and accessible by a computer. In addition, it is known to those of ordinary skill in the art that the communication medium usually includes a computer readable instruction, a data structure, a program module, or other data in a modulated data signal such as a carrier wave or another transmission mechanism, and may include any information delivery medium.

## Claims

1. A display module, comprising:
a display panel comprising a display portion, a bending portion, and a bonding portion, the display portion, the bending portion, and the bonding portion being sequentially connected, and the bending portion being folded to a backlight side of the display portion; and
a near field communication structure located on the backlight side of the display portion;
wherein the display portion, the near field communication structure, and the bonding portion are sequentially arranged in a direction perpendicular to the display portion, and an orthographic projection of the near field communication structure on the display portion at least partially overlaps with an orthographic projection of the bonding portion on the display portion.

2. The display module according to claim 1, further comprising a first back film layer located on a surface of the bonding portion close to the display portion, wherein the near field communication structure is configured to be adhered to the first back film layer.

3. The display module according to claim 2, wherein a surface of the near field communication structure facing the first back film layer is provided with a double-sided adhesive for adhering, and the double-sided adhesive is provided as an acrylic hot melt adhesive.

4. The display module according to claim 3, wherein a thickness of the double-sided adhesive is configured to be 0.02 mm to 0.05 mm.

5. The display module according to claim 2, further comprising a composite film provided between the near field communication structure and the display portion, wherein a thickness of the composite film is configured to be less than 0.16 mm.

6. The display module according to claim 5, wherein the composite film comprises a first film layer and a mesh adhesive, the first film layer and the mesh adhesive are stacked in the direction perpendicular to the display portion, and the first film layer is provided as a graphite layer, a foam adhesive layer, or a polyimide layer.

7. The display module according to claim 6, wherein a thickness of the first film layer is configured to be 0.05 mm to 0.07 mm, and a thickness of the mesh adhesive is configured to be 0.02 mm to 0.04 mm.

8. The display module according to claim 5, wherein the thickness of the composite film is configured to be 0.06 mm to 0.12 mm.

9. The display module according to claim 1, further comprising a conductive member for grounding the display panel;
wherein the near field communication structure comprises a ferrite plate and a copper foil, the ferrite plate and the copper foil are stacked in the direction perpendicular to the display portion, and the copper foil is located on a side of the ferrite plate away from the display portion; and
wherein the ferrite plate is provided with a first through hole, the conductive member penetrates the first through hole, one end of the conductive member abuts against the copper foil, and the conductive member is configured to be spaced apart from an inner side wall of the first through hole.

10. The display module according to claim 9, further comprising a composite film and a second back film layer, wherein the second back film layer is disposed on a surface of the display portion facing the near field communication structure,
the second back film layer, the composite film, and the near field communication structure are sequentially stacked in the direction perpendicular to the display portion;
the composite film is provided with a second through hole, the second through hole is in communication with the first through hole, and the first through hole and the second through hole constitute an accommodation cavity; and
one end of the conductive member away from the copper foil abuts against the second back film layer, the conductive member sequentially penetrates the first through hole and the second through hole, and the conductive member is configured to be spaced apart from an inner side wall of the second through hole.

11. The display module according to claim 10, wherein a plurality of conductive members are provided, a plurality of accommodation cavities are provided, and the conductive members and the accommodation cavities are provided in one-to-one correspondence.

12. The display module according to claim 10, wherein a cross-sectional shape of the conductive member in a plane parallel to the display portion is configured to be rectangular, circular, rhomboidal, triangular, trapezoidal or irregular pattern, and hole patterns of the second through hole and the first through hole are configured to be the same as the cross-sectional shape of the conductive member in the plane parallel to the display portion.

13. The display module according to claim 9, wherein the conductive member is provided as a conductive foam or a conductive double-sided adhesive.

14. The display module according to claim 9, wherein a cross-sectional area of the conductive member in a plane parallel to the display portion is configured to be greater than or equal to 5 mm².

15. The display module according to any one of claims 1 to 8, wherein the near field communication structure comprises a ferrite plate and a first trace disposed on the ferrite plate, and at least a part of an orthographic projection of the first trace on the display portion is configured to overlap with at least a part of the orthographic projection of the bonding portion on the display portion, or at least a part of the orthographic projection of the first trace on the display portion is configured to not overlap with the orthographic projection of the bonding portion on the display portion.

16. The display module according to any one of claims 1 to 14, further comprising a chip disposed on a surface of the bonding portion away from the near field communication structure, an orthographic projection of the chip on the display portion being within the orthographic projection of the near field communication structure on the display portion.

17. The display module according to any one of claims 1 to 14, wherein the orthographic projection of the near field communication structure on the display portion is provided as a first projection, the orthographic projection of the bonding portion on the display portion is provided as a second projection, and a projection area where the second projection overlaps with the first projection is configured to be greater than two-thirds of a projection area of the second projection.

18. The display module according to any one of claims 1 to 14, wherein a projection area of the orthographic projection of the near field communication structure on the display portion is not less than two-thirds of an area of the display portion.

19. The display module according to any one of claims 1 to 14, further comprising a cover plate, a curable optical adhesive, a polarizer, and an encapsulation layer that are located on a light emitting side of the display portion, wherein the encapsulation layer, the polarizer, the curable optical adhesive, and the cover plate are sequentially stacked in a direction away from the display portion.

20. A display device, comprising the display module according to any one of claims 1 to 19.
